# EUROPÄISCHE PATENTANMELDUNG

(11) **EP 4 181 384 A1**
(43) Veröffentlichungstag der Anmeldung: **17.05.2023**
(21) Anmeldenummer: 22203551.1
(22) Anmeldetag: 25.10.2022
(51) Int. Cl.: H02M 7/5387, H02P 5/74, H05K 7/14

(54) **UMRICHTER**

(30) Priorität: 15.11.2021 DE 102021129718
(71) Anmelder: STILL GmbH, 22113 Hamburg (DE)
(72) Erfinder: OSPER, Gerald, 22147 Hamburg (DE); SCHETTGEN, Nils, 22559 Hamburg (DE); ALTHOF, Carsten, 21031 Hamburg (DE)
(74) Vertreter: Patentship Patentanwaltgesellschaft

(57) **Zusammenfassung**

Die Erfindung betrifft einen Umrichter (1), insbesondere mehrphasiger Drehstromumrichter, zur Ansteuerung von elektrischen Maschinen. Es wird vorgeschlagen, dass der Umrichter (1) über, in einem gemeinsamen Umrichter-Gehäuse (G) integrierte, Umrichtermodule (UM) verfügt, die derart ausgebildet sind, dass mindestens drei Umrichterfunktionen zur Ansteuerung von mindestens drei elektrischen Maschinen ausgeführt werden.

## Beschreibung

Die Erfindung betrifft einen Umrichter, insbesondere einen mehrphasigen Drehstromumrichter, zur Ansteuerung von elektrischen Maschinen.

Mehrphasige Umrichter, beispielsweise dreiphasige Wechselrichter oder Frequenzumrichter, werden zur Speisung von mehrphasigen elektrischen Antriebsmaschinen aus einer Gleichspannungsquelle verwendet. Eingesetzt werden derartige Umrichter beispielsweise als Frequenzumrichter, die aus einer Gleichspannungsquelle einen Fahrmotor, beispielsweise einen Asynchronmotor, eines elektrisch angetriebenen Fahrzeugs, etwa eines Flurförderzeugs, ansteuern.

Die Gleichspannung kann aus einer Batterie oder einem Netzgleichrichter oder einem Generator als Gleichspannungsquelle bereitgestellt werden. Als Generator kann insbesondere ein Gleichspannungsgenerator oder ein Drehstromgenerator eingesetzt werden, dessen erzeugter Drehstrom in einem Gleichrichter gleichgerichtet wird.

Bekannt sind Umrichter zur Speisung von Drehfeldmaschinen in den Bauformen Einzelumrichter und Doppelumrichter. Doppelumrichter beinhalten zwei Umrichterfunktionen in einem Gehäuse. Mit ihnen können daher zwei Drehfeldmaschinen betrieben werden. Doppelumrichter sind kostengünstiger als zwei Einzelumrichter und werden daher verbreitet in Flurförderzeugen mit zwei oder vier Motoren eingesetzt. Fahrzeuge, beispielsweise Flurförderzeuge, mit drei elektrischen Motoren, zum Beispiel zwei elektrischen Fahrmotoren und einem elektrischen Pumpenmotor für eine Arbeitshydraulik, werden entweder mit drei Einzelumrichtern oder mit einem Doppel- und einem Einzelumrichter ausgestattet.

Des Weiteren sind Kombi-Umrichter bekannt. Diese enthalten in den Bauformen Einzel- und Doppelumrichter zusätzliche Funktionen zur Steuerung und Überwachung von Fahrzeugfunktionen.

Jeder Umrichter weist zwei Leistungsanschlüsse für die Zuführung der elektrischen Energie aus der Gleichspannungsquelle auf. Bei einer Gleichspannungsquelle, zum Beispiel einer Batterie, handelt es sich dabei um Gleichspannungsanschlüsse, so genannte DC-Anschlüsse. Die Verwendung mehrerer Umrichter in einem Fahrzeug erfordert mehrfachen Aufwand für die Zuführung der elektrischen Energie, da jeder Umrichter einzeln mit Spannung versorgt werden muss.

Der vorliegenden Erfindung liegt die Aufgabe zugrunde, einen Umrichter zur Verfügung zu stellen, der bei kostengünstiger Bauweise einen Betrieb mehrerer elektrischer Maschinen ermöglicht.

Diese Aufgabe wird erfindungsgemäß dadurch gelöst, dass der Umrichter über, in einem gemeinsamen Umrichter-Gehäuse integrierte, Umrichtermodule verfügt, die derart ausgebildet sind, dass mindestens drei Umrichterfunktionen zur Ansteuerung von mindestens drei elektrischen Maschinen ausgeführt werden.

Es wird somit erfindungsgemäß ein Mehrfach-Umrichter geschaffen, der zumindest drei Umrichterfunktionen in einem gemeinsamen Umrichter-Gehäuse ermöglicht, wodurch sich niedrige Gehäusekosten für die Umrichterfunktionen ergeben. Beispielsweise sind bei einem Dreifach-Umrichter die Umrichterfunktionen für drei elektrische Maschinen in einem gemeinsamen Umrichter-Gehäuse integriert. Die elektrischen Maschinen, zum Beispiel Elektromotoren, können dabei ähnlicher Leistungsklasse oder aber auch sehr unterschiedlicher Leistungsklasse sein. So kann es sich beispielsweise um einen Fahrmotor, einen Pumpenmotor und einen Motor für Hilfsantriebe, wie Lenkung oder Lüfter, eines Fahrzeugs, beispielsweise eines Flurförderzeugs, handeln. Auch Vielfach-Umrichter zur Speisung von mehr als drei elektrischen Maschinen sind möglich.

Elektronische Schaltungen im erfindungsgemäßen Mehrfach-Umrichter können kostengünstiger realisiert werden als in der Summe in mehreren getrennten Einzelumrichtern. Insbesondere kann die Zahl der erforderlichen Netzteile, Mikrocontroller und Kommunikationsschnittstellen reduziert werden.

Die Umrichterfunktionen können jeweils als Frequenzumrichter zur Ansteuerung einer Drehfeldmaschine ausgebildet sein und eine dementsprechende Anzahl, insbesondere sechs, Leistungshalbleiter aufweisen. Es ist ebenfalls möglich, dass mindestens eine der Umrichterfunktionen alternativ als Gleichspannungs-Steller zur Ansteuerung eines Gleichstrommotors ausgebildet sein kann, der entweder als vollständige H-Brücke oder als halbe H-Brücke, die aus einem ein Highside-Schalter und einem Lowside-Schalter gebildet ist, ausgeführt sein kann.

Gemäß einer besonders bevorzugten Ausgestaltung der Erfindung ist vorgesehen, dass die Umrichtermodule mindestens drei Leistungsmodule und mindestens ein gemeinsames Gleichspannungszwischenkreismodul umfassen. Dabei kann insbesondere für jede Umrichterfunktion, also für die Ansteuerung jeder elektrischen Maschine, ein eigenes Leistungsmodul mit jeweils mindestens einem Leistungshalbleiter und jeweils eigenen Leistungsstromausgängen für die jeweilige elektrische Maschine vorgesehen sein. Die mindestens drei Leistungsmodule sind insbesondere mit dem mindestens einen gemeinsamen Gleichspannungszwischenkreismodul elektrisch verbunden. Weiterhin kann für die Leistungsmodule und das mindestens eine gemeinsame Gleichspannungszwischenkreismodul ein gemeinsamer Gleichspannungs-Stromanschluss vorgesehen sein. Durch den gemeinsamen Gleichspannungs-Stromanschluss können insbesondere alle Leistungsmodule und das gemeinsame Gleichspannungszwischenkreismodul in einfacher Weise mit der Gleichspannungsquelle verbunden werden.

Durch den gemeinsamen Gleichspannungs-Stromanschluss kann insbesondere die Energie zuführende Verkabelung nur einfach vorhanden sein, wodurch Verkabelungsaufwand und Investitionskosten gespart werden können.

Dabei kann der gemeinsame Gleichspannungs-Stromanschluss insbesondere Stromschienen umfassen, die Stromanschlüsse des Gleichspannungs-Stromanschluss mit den Leistungsmodulen und dem Gleichspannungszwischenkreismodul verbinden. Mit derartigen Stromschienen können insbesondere die Stromanschlüsse des gemeinsamen Gleichspannungs-Stromanschlusses in einfacher Weise mit allen Leistungsmodulen und dem gemeinsamen Gleichspannungszwischenkreismodul verbunden werden.

Vorzugsweise kann jedes Leistungsmodul auf jeweils einer eigenen Leiterplatte untergebracht sein, und das gemeinsame Gleichspannungszwischenkreismodul auf einer eigenen Leiterplatte untergebracht sein.

Dabei können insbesondere die Leiterplatten der Leistungsmodule eine Leistungsmodul-Ebene bilden, während die Leiterplatte des gemeinsamen Gleichspannungszwischenkreismoduls eine Gleichspannungszwischenkreismodul-Ebene bildet.

Die Leistungsmodul-Ebene und die Gleichspannungszwischenkreismodul-Ebene können vorzugsweise in parallelen Ebenen und/oder übereinander, insbesondere direkt übereinander, angeordnet sein.

Insbesondere können die Leistungsmodul-Ebene und die Gleichspannungszwischenkreismodul-Ebene elektrisch und/oder mechanisch miteinander verbunden sein.

Vorzugsweise können hierzu insbesondere Stromschienen und/oder Steckverbinder und/oder Schraubverbindungen und/oder Lötstifte vorgesehen sein.

In einer praxisgerechten Ausgestaltung verfügt das gemeinsame Gleichspannungszwischenkreismodul vorzugsweise über Zwischenkreiskondensatoren. Die gemeinsam genutzten Zwischenkreiskondensatoren können insbesondere im Vergleich zu den bei separaten Einzel-Umrichtern verwendeten Zwischenkreiskondensatoren kleiner dimensioniert werden, da in der Regel die einzelnen Leistungsmodule nicht gleichzeitig mit hohem Strom betrieben werden und Ausgleichströme von einem zum anderen Leistungsmodul direkt fließen können und nicht gepuffert werden müssen.

Die einzelnen Leistungsmodule können insbesondere weiterhin so synchronisiert sein, dass sich in den Zwischenkreiskondensatoren eine minimale Stromwelligkeit ergibt. Dies führt zu einer geringeren elektromagnetischen Störaussendung des erfindungsgemäßen Umrichters. Die geringere Stromwelligkeit verringert die Belastung der Zwischenkreiskondensatoren. Daraus folgt eine höhere Lebensdauer und/oder eine Reduzierung der Kosten durch den Einsatz von Kondensatoren geringerer Güte und/oder Performance. Zudem ist eine verringerte Anzahl von Zwischenkreiskondensatoren möglich.

Insbesondere kann das gemeinsame Gleichspannungszwischenkreismodul auch über eine Steuerelektronik verfügen, die bevorzugt alle Leistungsmodule ansteuert.

Bei Umrichtern, die insbesondere für einen Fahrantrieb vorgesehen sind, können insbesondere von den Leistungshalbleitern sehr große Ströme geschaltet werden und es entsteht viel Abwärme durch die Verlustleistung. Daher ist gemäß einer bevorzugten Ausgestaltung vorgesehen, dass der Umrichter vorzugweise über einen gemeinsamen Kühlkörper zur Abführung der Abwärme verfügen. Der gemeinsam genutzte Kühlkörper kann kleiner dimensioniert werden, da in der Regel die einzelnen Umrichtermodule nicht gleichzeitig mit hohem Strom betrieben werden.

Insbesondere kann das gemeinsame Umrichter-Gehäuse aus isolierendem Spritzgussmaterial gebildet sein.

Beim Einbau des Umrichters in ein Fahrzeug, insbesondere in ein batterie-elektrisch betriebenes Flurförderzeug, ergeben sich durch die reduzierte Anzahl von energiezuführenden Leistungsanschlüssen (Gleichspannungs-Stromanschluss) und Signalleitungen sowie die zugehörigen Steckverbinderpins verringerte Kosten für die Montage des Fahrzeugs. Gleichzeitig wird die Zuverlässigkeit des Fahrzeugs durch die Reduktion von potentiellen Schwachstellen erhöht.

Gemäß einer Weiterbildung der Erfindung kann insbesondere in das gemeinsame Umrichter-Gehäuse eine Fahrzeugsteuerungseinrichtung integriert sein. Dadurch kann auf eine als getrennte Baugruppe ausgebildete Fahrzeugsteuerungseinrichtung verzichtet werden. Mit der Integration der Fahrzeugsteuerungseinrichtung, beispielsweise eines Flurförderzeugs, in das Umrichter-Gehäuse können Gehäuse-, Verkabelungs- und Schaltungsaufwände weiter reduziert werden.

Gemäß einer vorteilhaften Ausgestaltungsform der Erfindung können insbesondere die Umrichtermodule ausgebildet sein, um mit unterschiedlichen Taktfrequenzen betrieben zu werden.

Insbesondere eine Anzahl der Umrichtermodule, vorzugsweise sämtliche Umrichtermodule, können hierzu insbesondere derart ausgebildet sein, dass diese mit unterschiedlichen Taktfrequenzen betrieben werden können.

Gemäß einer vorteilhaften Ausgestaltungsform der Erfindung können insbesondere die Umrichtermodule ausgebildet sein, um mit einer gemeinsamen, synchronisierten Taktfrequenz betrieben zu werden.

Insbesondere eine Anzahl der Umrichtermodule, vorzugsweise sämtliche Umrichtermodule können hierzu insbesondere derart ausgebildet sein, dass diese mit einer gemeinsamen, synchronisierten Taktfrequenz betrieben werden können.

Insbesondere bevorzugt kann vorgesehen sein, dass eine erste Anzahl der Umrichtermodule ausgebildet ist, um mit einer gemeinsamen, synchronisierten Taktfrequenz betrieben zu werden, und eine zweite Anzahl der Umrichtermodule ausgebildet ist, um mit einer unterschiedlichen Taktfrequenz betrieben zu werden.

Weitere Vorteile und Einzelheiten der Erfindung werden beispielhaft anhand des in der schematischen Figur dargestellten Ausführungsbeispiels näher erläutert.

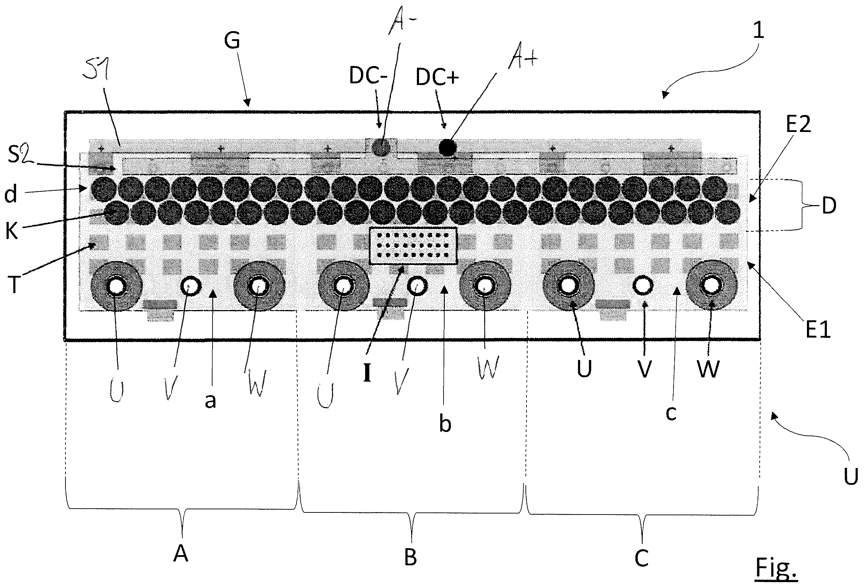

Die Figur zeigt eine Draufsicht auf einen erfindungsgemäßen Umrichter 1, der im dargestellten Ausführungsbeispiel als Dreifach-Umrichter ausgebildet ist.

Der Umrichter 1 verfügt über drei Leistungsmodule A, B, C und ein gemeinsames Gleichspannungszwischenkreismodul D. Jedes der drei Leistungsmodule A, B, C weist eine eigene Leiterplatte a, b, c mit, als Leistungstransistoren ausgebildeten, Leistungshalbleitern T auf. Das Gleichspannungszwischenkreismodul D weist eine einzelne Leiterplatte d mit Zwischenkreiskondensatoren K auf. Außerdem weist die Leiterplatte d eine, in der Figur nicht näher dargestellte, Steuerelektronik auf, die alle Leistungsmodule A, B, C ansteuert.

Die Leistungsmodule A, B, C und das Gleichspannungszwischenkreismodul D bilden die Umrichtermodule UM des Umrichters 1. Die Umrichtermodule UM sind in einem gemeinsamen Umrichter-Gehäuse G untergebracht.

Die Leiterplatten a, b, c der Leistungsmodule A, B, C können eine Leistungsmodul-Ebene E1 und die Leiterplatte d des Gleichspannungszwischenkreismoduls D kann eine Gleichspannungszwischenkreismodul-Ebene E2 bilden. Die Ebenen E1 und E2 können parallel direkt übereinander angeordnet und elektrisch und mechanisch miteinander verbunden. Somit können die Leistungshalbleiter T der Leistungsmodule A, B, C auf die gemeinsamen Zwischenkreiskondensatoren K des Gleichspannungszwischenkreismoduls D zugreifen.

Der erfindungsgemäße Umrichter 1 weist einen gemeinsamen Gleichspannungs-Stromanschluss DC+, DC- auf, mit dem der Umrichter 1 an eine Gleichspannungsquelle, zum Beispiel eine Batterie, angeschlossen werden kann und mit Strom versorgt werden kann. Der Gleichspannungs-Stromanschluss DC+, DC- umfasst vorzugsweise zwei Stromanschlüsse A+, A- zum Anschluss an die Gleichspannungsquelle und zwei Stromschienen S1, S2. Die Stromschiene S1 ist mit dem Stromanschluss A+ versehen und verbindet die Leistungsmodule A, B, C und das Gleichspannungszwischenkreismodul D mit dem Stromanschluss A+. Die Stromschiene S2 ist mit dem Stromanschluss A- versehen und verbindet die Leistungsmodule A, B, C und das Gleichspannungszwischenkreismodul D mit dem Stromanschluss A-. Der Umrichter 1 kann somit mit nur zwei Verbindungskabeln, die von der Gleichspannungsquelle, zum Beispiel eine Batterie, zu den Stromanschlüssen A+ und A- geführt sind, mit elektrischer Energie aus der Gleichspannungsquelle versorgt werden.

Die Leistungsmodule A, B, C verfügen im dargestellten Ausführungsbeispiel jeweils über drei Leistungsstromausgänge U, V, W zum Anschluss jeweils einer elektrischen Maschine, beispielsweise einer Drehfeldmaschine. Somit können drei verschiedene elektrische Maschinen an denselben Umrichter 1 angeschlossen und von den jeweiligen Leistungsmodulen A, B, C einzeln angesteuert werden.

Weiterhin ist im dargestellten Ausführungsbeispiel ein Steuersignal-Stecker I am Umrichter 1 vorgesehen, der mit der Steuerelektronik, die an der Leiterplatte d des Gleichspannungszwischenkreismodul D angeordnet ist, verbunden ist.

Nicht näher dargestellt ist ein gemeinsamer Kühlkörper des Umrichters 1, der sich zur Abführung der Abwärme aller Leistungsmodule A, B, C über alle Leistungsmodule A, B, C erstreckt.

## Patentansprüche

1. Umrichter (1), insbesondere mehrphasiger Drehstromumrichter, zur Ansteuerung von elektrischen Maschinen, **dadurch gekennzeichnet, dass** der Umrichter (1) über, in einem gemeinsamen Umrichter-Gehäuse (G) integrierte, Umrichtermodule (UM) verfügt, die derart ausgebildet sind, dass mindestens drei Umrichterfunktionen zur Ansteuerung von mindestens drei elektrischen Maschinen ausgeführt werden.

2. Umrichter (1) nach Anspruch 1, **dadurch gekennzeichnet, dass** die Umrichtermodule (UM) mindestens drei Leistungsmodule (A, B, C) und mindestens ein gemeinsames Gleichspannungszwischenkreismodul (D) umfassen, wobei für jede Umrichterfunktion ein eigenes Leistungsmodul (A, B, C) mit jeweils mindestens einem Leistungshalbleiter (T) und jeweils eigenen Leistungsstromausgängen (U, V, W) für die jeweilige elektrische Maschine vorgesehen ist, und die mindestens drei Leistungsmodule (A, B, C) mit dem mindestens einen gemeinsamen Gleichspannungszwischenkreismodul (D) elektrisch verbunden sind, und für die Leistungsmodule (A, B, C) und das mindestens eine gemeinsame Gleichspannungszwischenkreismodul (D) ein gemeinsamer Gleichspannungs-Stromanschluss (DC+, DC-) vorgesehen ist.

3. Umrichter (1) nach Anspruch 2, **dadurch gekennzeichnet, dass** der gemeinsame Gleichspannungs-Stromanschluss (DC+, DC-) Stromschienen (S1, S2) umfasst, die Stromanschlüsse (A+, A-) des Gleichspannungs-Stromanschlusses (DC+, DC-) mit den Leistungsmodulen (A, B, C) und dem Gleichspannungszwischenkreismodul (D) verbinden.

4. Umrichter (1) nach Anspruch 2 oder 3, **dadurch gekennzeichnet, dass** jedes Leistungsmodul (A, B, C) auf jeweils einer eigenen Leiterplatte (a, b, c) untergebracht ist, und das gemeinsame Gleichspannungszwischenkreismodul (D) auf einer eigenen Leiterplatte (d) untergebracht ist.

5. Umrichter (1) nach Anspruch 4, **dadurch gekennzeichnet, dass** die Leiterplatten (a, b, c) der Leistungsmodule (A, B, C) eine Leistungsmodul-Ebene (E1) bilden und die Leiterplatte (d) des gemeinsamen Gleichspannungszwischenkreismoduls (D) eine Gleichspannungszwischenkreismodul-Ebene (E2) bildet.

6. Umrichter (1) nach Anspruch 5, **dadurch gekennzeichnet, dass** die Leistungsmodul-Ebene (E1) und die Gleichspannungszwischenkreismodul-Ebene (E2) in parallelen Ebenen (E1, E2) angeordnet sind, insbesondere direkt übereinander angeordnet sind, und elektrisch und/oder mechanisch miteinander verbunden sind.

7. Umrichter (1) nach Anspruch 5 oder 6, **dadurch gekennzeichnet, dass** die Leistungsmodul-Ebene (E1) und die Gleichspannungszwischenkreismodul-Ebene (E2) mittels Stromschienen und/oder Steckverbindern und/oder Schraubverbindungen und/oder Lötstiften verbunden sind.

8. Umrichter (1) nach einem der Ansprüche 2 bis 7, **dadurch gekennzeichnet, dass** das gemeinsame Gleichspannungszwischenkreismodul (D) über Zwischenkreiskondensatoren (K) verfügt.

9. Umrichter (1) nach einem der Ansprüche 2 bis 8, **dadurch gekennzeichnet, dass** das gemeinsame Gleichspannungszwischenkreismodul (D) über eine Steuerelektronik verfügt.

10. Umrichter (1) nach einem der Ansprüche 1 bis 9, **dadurch gekennzeichnet, dass** der Umrichter (1) über einen gemeinsamen Kühlkörper verfügen.

11. Umrichter (1) nach einem der Ansprüche 1 bis 10, **dadurch gekennzeichnet, dass** das gemeinsame Umrichter-Gehäuse (G) aus isolierendem Spritzgussmaterial gebildet ist.

12. Umrichter (1) nach einem der Ansprüche 1 bis 11, **dadurch gekennzeichnet, dass** in das gemeinsame Umrichter-Gehäuse (G) eine Fahrzeugsteuerungseinrichtung integriert ist.

13. Umrichter (1) nach einem der Ansprüche 1 bis 12, wobei die Umrichtermodule (UM) ausgebildet sind, um mit unterschiedlichen Taktfrequenzen betrieben zu werden.

14. Umrichter (1) nach einem der Ansprüche 1 bis 13, wobei die Umrichtermodule (UM) ausgebildet sind, um mit einer gemeinsamen, synchronisierten Taktfrequenz betrieben zu werden.
